(19) **Europäisches Patentamt**

**European Patent Office**

**Office européen des brevets**

(11) **EP 1 267 409 A2**

(12) **EUROPEAN PATENT APPLICATION**

(43) Date of publication:
**18.12.2002 Bulletin 2002/51**

(51) Int Cl.7: **H01L 27/08**, H01L 29/93

(21) Application number: **02396078.4**

(22) Date of filing: **28.05.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **13.06.2001 FI 20011254**

(71) Applicant: **Micro Analog Systems OY**
**02770 Espoo (FI)**

(72) Inventor: **Routama, Jarkko**
**02340 Espoo (FI)**

(74) Representative: **Äkräs, Tapio**
**Kolster Oy Ab,**
**Iso Roobertinkatu 23**
**00120 Helsinki (FI)**

(54) **Capacitor**

(57) A monolithic capacitor formed on a semiconductor substrate (201) has a large parasitic capacitance ($C_{par}$) from the bottom plate (205) of the capacitor to the substrate. The value of this parasitic capacitance is reduced by connecting it in series with a smaller substrate capacitance ($C_{sub}$). The substrate capacitance dominates the total value, if it is much smaller than the bottom plate capacitance. The small substrate capacitance under the monolithic capacitor is produced by adding under the monolithic capacitor a semiconductor well (202') of a different type than a semiconductor substrate or body on which the monolithic capacitor is formed. This well is either left floating or connected with a high-value resistor to an AC ground.

FIG.3

Metal layer
Substrate contact
Insulator
P-type substrate
N-type epi
Isolation ring

EP 1 267 409 A2

## Description

## Field of the Invention

This invention relates generally to capacitors, and more particularly, to monolithic capacitors formed on a semiconductor substrate.

## Background of the Invention

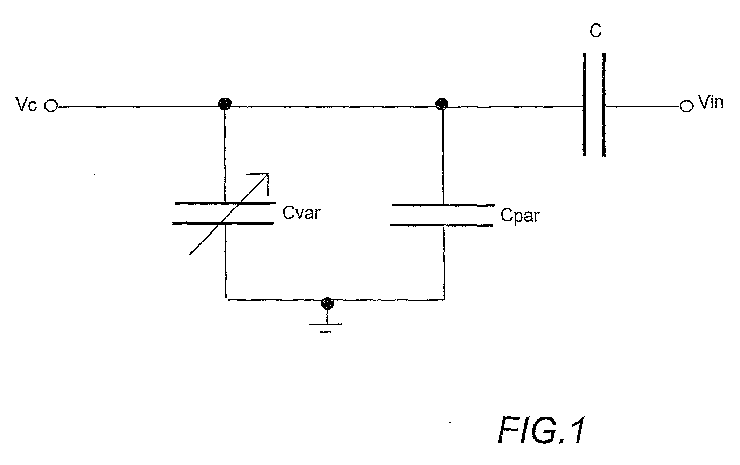

A monolithic capacitor consists of two conductive layers formed on a semiconductor substrate (also referred to as a semiconductor body or wafer). A monolithic capacitor consists of a first layer provided directly on or in the substrate and forming the bottom plate of the capacitor, a dielectric (insulator) layer on the bottom plate, and a second conductive layer formed on the dielectric layer and forming the top plate of the capacitor. There are various combinations of materials used in the top and bottom plates, such as metal-metal, poly-metal, poly-poly, moly-metal ones. Such a monolithic capacitor has a large parasitic capacitance from the bottom plate to the substrate, typically about five percent of the capacitor value. This parasitic capacitor is connected from the bottom plate of the capacitor to the AC ground, which causes problems in some cases. For example, if the capacitor C is used as a DC coupling capacitor of a variable capacitor element $C_{var}$, as illustrated in Figure 1, the parasitic capacitance $C_{par}$ of the capacitor C increases the total capacitance value of the variable capacitor $C_{var}$, and thereby also affects the capacitance-to-voltage curve of the variable capacitor $C_{var}$.

## Disclosure of the Invention

An object of the invention is a monolithic capacitor which has a reduced parasitic bottom plate capacitance.

This object is achieved by capacitors disclosed in the attached independent claims. Preferred embodiments of the invention are disclosed in the attached dependent claims.

The basic idea of the present invention is to reduce a value of a parasitic bottom plate capacitance by connecting this parasitic capacitance in series with a smaller substrate capacitance. The substrate capacitance dominates the total value, if it is much smaller than the bottom plate capacitance. The small substrate capacitance under the monolithic capacitor is produced by adding, under the monolithic capacitor, a semiconductor well of a different type than a semiconductor substrate or body on which the monolithic capacitor is formed. This well is either left floating or connected with a high-value resistor to an AC ground.

In an embodiment of the invention, the well is a slightly diffused well. The problem in this embodiment is that on one hand, the substrate capacitance of even a quite slightly diffused well is quite high, but on the other hand, if the well is diffused only very slightly, the value of the substrate capacitance may depend on the operation conditions, i.e. the temperature or the supply voltage, which is not desired in many cases.

In the preferred embodiment of the invention, this dependence on the temperature or the supply voltage is reduced by isolating the substrate under the monolithic capacitor from the rest of a circuit on the substrate.

In a further embodiment of the invention, the isolation is provided by providing a guard ring around the semiconductor well for connecting the semiconductor substrate to a ground potential. The well is preferably defined by said guard ring which extends to the semiconductor substrate and is connected to a ground potential. In an embodiment of the invention, the guard ring is a deep p-type diffusion, while the semiconductor substrate is a p-type substrate and the well is an n-type well.

In an embodiment of the invention, a monolithic capacitor is formed on a multi-layer substrate having a bottom semiconductor layer of a first type and a thinner top semiconductor layer of a second type. The well according to an embodiment of the invention is defined in the top semiconductor layer under the monolithic capacitor by a guard ring which extends through the top semiconductor layer to the bottom semiconductor layer and is connected to a ground potential.

In an embodiment of the invention, the well is left floating or connected by a high-value resistor to an AC ground, such as a constant DC voltage source, which prevents the changes in the substrate capacitance value in different operation conditions.

The invention relates also to a use of the capacitor according to the invention as a DC coupling capacitor for a variable capacitor element.

## Background of the Invention

The invention is now described by means of preferred embodiments with reference to the attached drawings, in which

> Figure 1 is a circuit diagram illustrating the use of the monolithic capacitor according to the invention as a DC coupling capacitor of a variable capacitor element,
> Figure 2 is a cross-sectional diagram of a capacitor according to a first embodiment of the invention, and
> Figure 3 is a cross-sectional diagram of a capacitor according to a second embodiment of the invention.

## A Detailed Description of the Invention

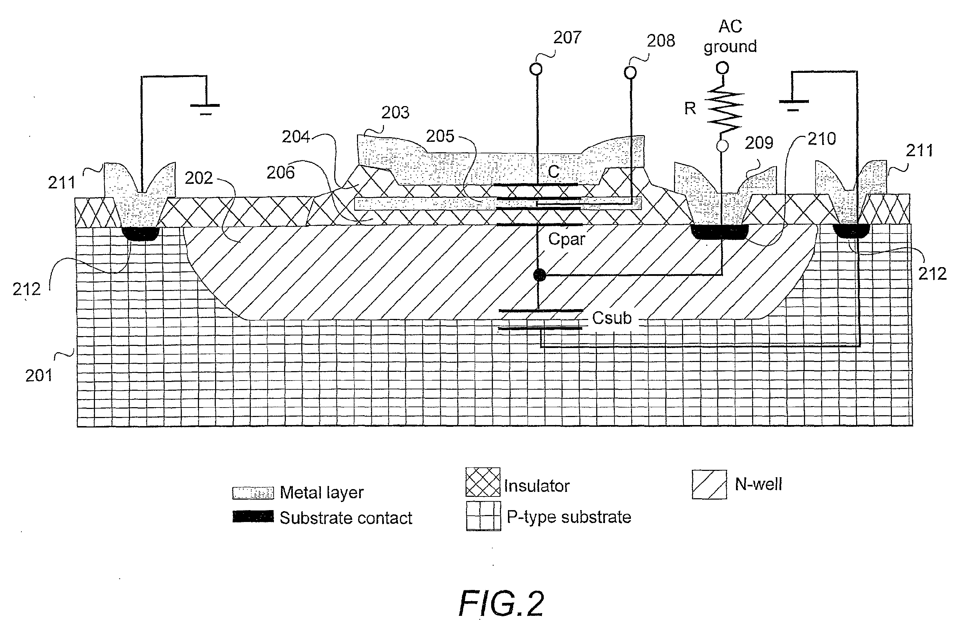

In Figure 2, a monolithic capacitor provided on a p-type substrate 201 comprises a first conductive layer 1 forming a top plate of the capacitor and a second conductive layer 205 forming a bottom plate of the capacitor.

Between the top plate 203 and the bottom plate 205 there is an insulator layer 204, such as SiO$_2$ layer. The basic capacitance C of the monolithic capacitor is formed between the top and the bottom plates 203 and 205. In the embodiment shown in Figure 2, the top plate also functions as a connection terminal. The bottom plate 205 is also connected to a corresponding connection terminal. Typically, these terminals are metal strips (or strips made of some other conductive material) which connect the top and the bottom plates to other circuitry on an integrated chip as illustrated by reference numerals 207 and 208 in Figure 2. The material of the top and the bottom plates may be any suitable material, and the top and the bottom plates may be made of different materials. Examples of combinations of the top and the bottom plate materials include metal-metal, poly-metal, poly-poly and poly-metal.

Although the specific type of monolithic capacitor is described above as an example, the present invention is applicable to any monolithic capacitor which has a top and a bottom plate.

In accordance with the present invention, an n-type well 202 is provided in the p-type substrate 201 under the monolithic capacitor. The bottom plate 205 is isolated from the well 202 by a dielectric (insulating) layer, such as an Si layer. The n-type well 202 is substantially wider than the top and the bottom plates 203 and 205. The well 202 is slightly or weakly diffused or doped with As, Sb or an other slowly diffusing dobent. Similarly, as in the prior art capacitors, there is an undesired parasitic capacitance C$_{par}$ between the bottom plate 205 and the underlying substrate, in this case the n-type well 202. However, in the capacitor according to the present invention, a further capacitance, referred to as a substrate capacitance C$_{sub}$, is established at the junction between the n-type well 202 and the p-type substrate 201. Due to the weak diffusion of the n-type layer, the value of the substrate capacitance C$_{sub}$ is small in comparison with the value of the parasitic capacitance C$_{par}$. As the substrate capacitance C$_{sub}$ is connected in series with the parasitic capacitance C$_{par}$, the total parasitic capacitor value can be calculated from equation 1:

$$C_{partot} = \frac{C_{par}C_{sub}}{C_{par}+C_{sub}}$$

Equation 1 shows that the substrate capacitance C$_{sub}$ dominates the total value of the parasitic capacitance when it is much smaller than the parasitic capacitance C$_{par}$ of the bottom plate 205. Thus, the parasitic capacitance and the related problems can be reduced by means of the present invention.

The n-type well can be left floating, i.e. it is not necessarily connected to any voltage or ground. However, in the embodiment shown in Figure 2, a metal terminal 209 and a substrate contact 210 are provided for connecting the well 202 to an AC ground (e.g. to a constant DC voltage source via a high value resistor R). This reduces the changes in the value of the substrate capacitance C$_{sub}$ in different operation conditions, i.e. temperature or supply voltage. Finally, a metallic terminal ring 211 with an underlying substrate contact 212 is provided around the n-type well 202 for connecting the surrounding p-type substrate 201 to the ground. As used herein, the term ring refers to any shape, such as circular or rectangular, which is suitable for isolating the well 202 and the capacitor from the other circuitry on an integrated chip. The connection of the p-type substrate to the ground via the substrate contacts 212 and metal terminals 211 reduces the dependence of the value of the substrate capacitance C$_{sub}$ on the supply voltage. The supply voltage may vary in some degree due to the other circuitry on the integrated chip.

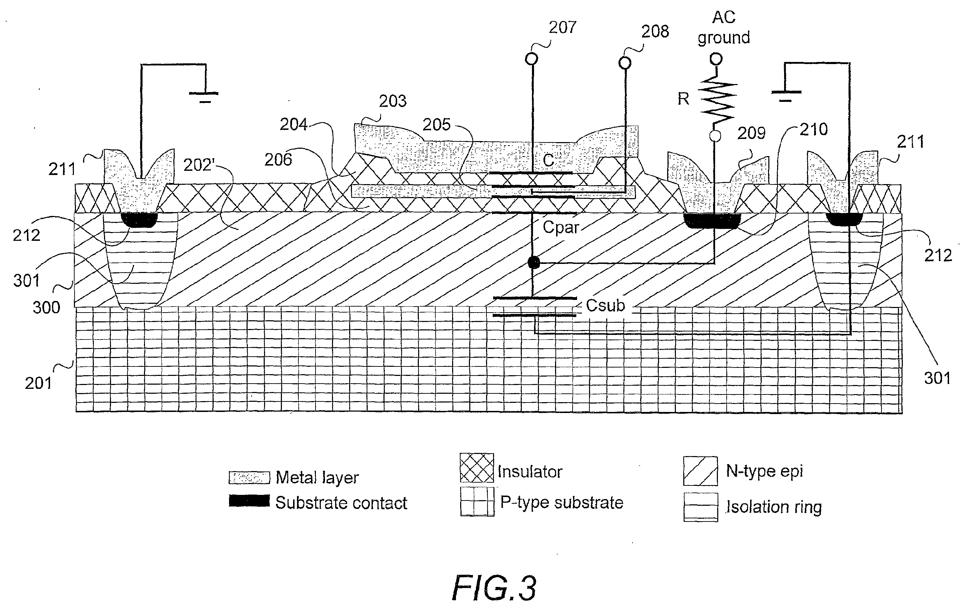

In the embodiment shown in Figure 3, the dependence of the substrate capacitor C$_{sub}$ on the operation conditions, such as the temperature and the supply voltage, is further reduced, which allows very weak diffusion of the n-type well and thereby smaller substrate capacitance C$_{sub}$. In the embodiment of Figure 3, a double layer wafer or substrate is used which has a thin layer of different type of material on a p- or n-type of substrate body. In Figure 3, a thin n-type layer 300 is provided on the p-type wafer (substrate) 201. The n-type well 202 according to the present invention is defined in the n-type layer 300 by means of isolating or a guard ring which extends through the layer 300 to the p-type substrate 201. At the top end, the isolating ring 301 is connected by the substrate contact 212 and the metal contact terminal 211. Otherwise the well 202' is essentially similar to the well 202 in Figure 2. The well 202' is either left floating or connected to an AC ground through the substrate contact 210, the contact terminal 209, and the high value resistor R in a similar manner to that in Figure 2. The monolithic capacitor comprises a top plate 203, a first insulator layer 204, a bottom plate 205 and a second insulator layer 206 in a similar manner to that in Figure 2.

The high value resistor R in Figures 1 and 2 is preferably formed on the same substrate as the monolithic capacitor according to the present invention.

The capacitor according to the invention can be used as a DC coupling capacitor of a variable capacitor element as illustrated in Figure 1. The variable capacitor element may, for example, be an integrated varactor described in the co-pending Finnish application titled "Integrated varactor" and having the same filing date. The monolithic capacitor and the variable capacitor element are preferably integrated on the same integrated circuit chip.

Now that the preferred embodiments of the present invention have been described, it will be apparent to one of skill in the art that other embodiments incorporating the concept of the present invention may be used. Therefore, the present invention should only be limited by the spirit and scope of the appended claims.

## Claims

1. A capacitor formed on a semiconductor body of a first conductivity type, **characterized by** comprising the following layers in the following order
   a first conductive layer forming a top plate of said capacitor,
   a first insulator layer,
   a second conductive layer forming a bottom plate,
   a second insulator layer,
   a semiconductor well of a second conductivity type on the semiconductor body of the first conductivity type.

2. A capacitor according to claim 1, **characterized by** a third terminal being connected to the semiconductor well in order to connect the semiconductor well to a DC bias voltage and AC ground through a high value resistor.

3. A capacitor according to claim 2, **characterized in that** the high-value resistor is formed in the semiconductor body.

4. A capacitor according to one of claims 1 to 3, **characterized by** a guard ring being arranged around the semiconductor well for connecting the semiconductor body to a ground potential.

5. A capacitor according to one of claims 1 to 3, **characterized in that** the well defined by a guard frame extends to the semiconductor body and is connected to a ground potential.

6. A capacitor according to claim 5, **characterized in that** the guard ring is a deep p-type diffusion.

7. A capacitor according to any one of claims 1 to 6, **characterized in that** the semiconductor body of the first type is a p-type substrate and the well is an n-type well.

8. A capacitor formed on a semiconductor body and having two terminals, **characterized by** the semiconductor body being a multilayer substrate having a bottom semiconductor layer of a first type and a thinner top semiconductor layer of a second type, the capacitor comprising the following layers in the following order
   a first conductive layer forming a top plate of said capacitor,
   a first insulating layer,
   a second conductive layer forming a bottom plate of said capacitor,
   a second insulating layer,
   a well defined in the top semiconductor layer by a guard ring which extends through said top semiconductor layer to the bottom semiconductor layer and is connected by a ground potential.

9. A capacitor according to claim 8, **characterized by** a third terminal being connected to the semiconductor well in order to connect the semiconductor well to a DC bias voltage and AC ground through a high value resistor.

10. A capacitor according to claim 9, **characterized in that** the high-value resistor is formed in the semiconductor body.

11. A capacitor according to claim 8, 9 or 10, **characterized in that** said guard ring is a deep p-type diffusion.

12. A capacitor according to any of claims 8 to 11, **characterized in that** the top semiconductor layer is an n-type layer and the bottom semiconductor layer is a p-type layer.

13. A use of a capacitor according to any one of claims 1 to 12 as a DC-coupling capacitor for a variable capacitor element.

FIG.1

*FIG.2*

EP 1 267 409 A2

FIG.3

Metal layer · Insulator · N-type epi · Substrate contact · P-type substrate · Isolation ring

EP 1 267 409 A2